# EUROPEAN PATENT APPLICATION

(11) **EP 3 182 536 A1**
(43) Date of publication of application: **21.06.2017**
(21) Application number: 15200555.9
(22) Date of filing: 16.12.2015
(51) Int. Cl.: H02B 1/20, H02B 1/30, F16L 3/13, F16L 3/23, H02G 3/32

(54) **CABLE FIXATION ELEMENT IN LOW VOLTAGE COMPARTMENTS**

(71) Applicant: ABB Schweiz AG, 5400 Baden (CH)
(72) Inventor: Zitzmann, Robby, 40883 Ratingen (DE)
(74) Representative: Schmidt, Karl Michael

(57) **Abstract**

The invention relates to a cable fixation element in low voltage compartments with an openable ring element, through which a number of cables can be aligned in parallel, wherein the cable fixation element has means, by which the cable fixation element can be fixed on a cable mounting board, according to claim 1.

In order to to enhance the construction of such cable fixation element in low voltage compartments in such, that no additional space is needed to open the cable fixation elements, and that a high amount of parallel aligned cables can be fixed, the invention is, that the ring is openable in that way, that the physical opening direction is perpendicular to the long axis of the cables, which have to be placed in the fixation element.

## Description

The invention relates to a cable fixation element in low voltage compartments with an openable ring element, through which a number of cables can be aligned in parallel, wherein the cable fixation element has means, by which the cable fixation element can be fixed on a cable mounting board, according to claim 1.

In low voltage compartments, a high amount of cables needed to be lead and handled. For realizing this, content cable holders are state of the art. Usually cable holder are built up like closed rings or openable rings, or u-shaped. U-shaped cable holder or fixation elements cannot really fix the position of cables or cable harnesses.

The well known closed ring is stiff but the disadvantage is, that the cables must be pulled through the hole. This results unfortunately in additional time of mounting and installation of the cables, or the complete wiring. U-shaped cable holders can be equipped fast with cables, but due to that, they are an open profile, and they are not as stiff enough, like closed cable holders. Therefore they cannot be equipped with the same amount of wires than the closed cable holders.

To overcome that problem, systems are known, which are open and can be closed later. The opening direction is oriented perpendicular to the cables along axis orientation. The disadvantages of these systems are, that they are based on two parts, or that the user have to close them by the need of two hands and usually the access to the position, where the cable holders are placed, is not as good for that. Furthermore, an opening direction perpendicular to the long axis of the wiring, needs additional space, which finally reduces the available cross-section of the cable holder, and with that the possible number of cables is reduced.

Considering all these disadvantages in the state of the art, it is the object of the invention, to enhance the construction of such cable fixation element in low voltage compartments in such, that no additional space is needed to open the cable fixation elements, and that a high amount of parallel aligned cables can be fixed.

The aforesaid problems are overcome with the features of claim 1.

Further advantageous embodiments are given in the depending claims.

According to the above mentioned object, the invention is, that the ring is openable in that way, that the physical opening direction is perpendicular to the long axis of the cables, which have to be placed in the fixation element.

For such a cable fixation element in low voltage compartments with an openable ring element, through which a number of cables can be aligned in parallel, wherein the cable fixation element has means, by which the cable fixation element can be fixed on a cable mounting board, the invention is, that the ring is openable in that way, that the physical opening direction is perpendicular to the long axis of the cables, which have to be placed in the fixation element.

The basical feature of the application is, that the opening direction of the cable fixation element in function of a cable holder, is in line with the cables, from the side. As there is no movement to the top when opening the cable fixation element, no space is required here for opening and the complete space can be used for the cables.

In a further advantageous embodiment, the ends of the openable ring are provided with complementarily formed c-structured portions, like hooks, which interlocks in the closed position of the fixation element, and can be opened by a sidewarded relative contrary side movement in a remove direction, and can be closed by a movement in succession to another.

So these c-structured portions can be interpretated as closing noses of the cable fixation element and are designed in that way, that the force created by the cables in closed direction enforces the closing but can be opened for all that easily with two fingers during installation or maintanance. This is realized by the special arrangement of the designed bevels in the nose area.

A further embodiment of the invention is, that the cable fixation element has a fixing nose for an intended twist protection, which ensures that the cable fixation element can be assembled in one direction only, which ensures that the opening is on the right position for installation and maintenance. As the fixing point and the integrated twist protection are different in size, in addition this guarantees a unique installation direction to avoid wrong installation in subassemblies.

In a further advantageous embodiment of the invention, the cable fixation element has a further integrated fixing element, which is additionally applicable for fixing the head profile for low voltage-components too.

In a further embodiment, the cable fixation element can be used for sideward application, if the space or the border conditions demand this orientation.

In a further advantageous embodiment, the cable fixation element including all aforesaid portions, fixing element, fixing nose and c-structured portions are formed as a one-piece element, so that all aforesaid parts and portions are integrally formed at the cable fixation element.

In a very important embodiment of the invention, the frame structure of the cable fixation element is embellished at all sides of the frame in interconnected double layers, except of the top side, where the C-structued portions are implemented.

This results first in an high flexibility, but secondly also in a prevention of a break

In a final advantageous embodiment, the cable fixation element is embellished as injection or cast moulded element.
With that, the fixation element is easy in production with constant quality.

The fixing of the cable fixation element is used for fixing the head profile to. Because of that, a separate fixing of the head profile is not necessary anymore. This saves fixing material and assembling time.

The wires can be applicated faster also in areas where the space and the access is constricted. Therefore the assembling time during production and during service is less.

More wires can be applicated in the same space. The cable fixation element can be assembled in only one defined direction which ensures that later the cable fixation element is positioned correct for placing in the wires for production or later for service.

An embodiment of the invention is shown in the drawing, showing the features in details.
- Figure 1:: Perspective view of the cable fixation element
- Figure 2:: Installation of the cable fixation element in a switchboard

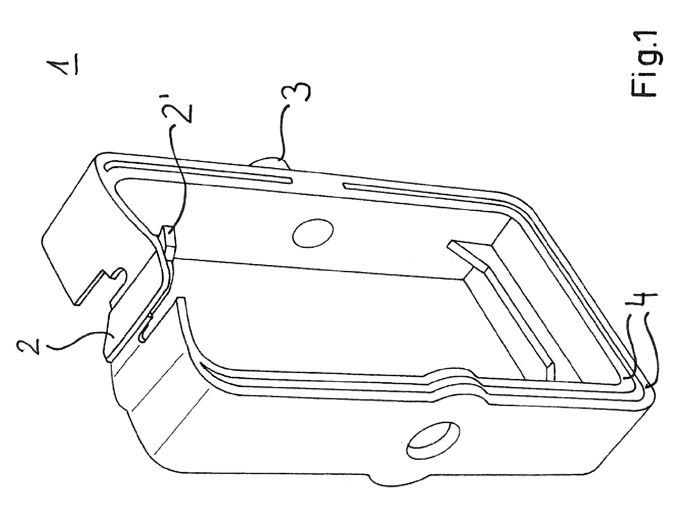

Figure 1 shows a perspective side view of the invention related cable fixation element. Like it is visible, the sides of the openable o-ring shaped form of the cable fixation element are embellished with interconnected double layers. The top of the cable fixation element is provided with the c-shaped portions, like complementary hooks. It is clear, that in order to open or to close the cable fixation element the element as such has to be moved or bended at the top portion in a direction parallel to the cable alignment through the o-ring shaped cable fixation element. The displayed position of the c-structured portions is opend. For closing, these portions has to be moved into a position, that the c-shapd portions grip or snatch into one another.

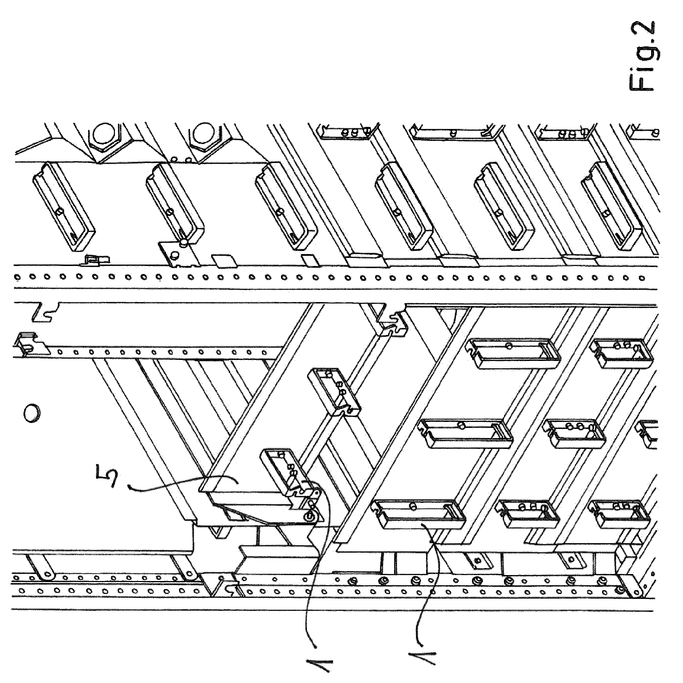

Figure 2 shows the possible arrangements of the cable fixation elements in a switchboard. Fixation noses are integrally formed at one small side as well as on at least one long side of the cable fixation element, in such, that they can be fastend to the switchboard for a flat cable arrangement close to the fixation sheet of the switchboard, or flat in a kind of a lying arrangement of a cable harness.

Furthermore, the integrated fixation nose at the cable fixation element allows to rotate the orientation, in order to follow the intended cable alignment also, in changing the angle of installation.

So, the invention is a new cable fixation element, which can be handled, that means opened and closed, by the use of two fingers only. The open situation gave the installation worker the chance to bring in or take out the cables as fast as possible. The closed situation fix the cables and make the application more stiff and stable.

The fixation element is constructed in its closed position, like a closed 0-ring. On the top the beam is opened. The two opened ends of the beam are designed like two C-structured complementary portions, like hooks with a c-shape, which can be closed by twisting them with two fingers.

The two c-shaped portions or hooks are designed in that way, that if they are closed and filled with wires the weight of the wires reinforce the closing situation. Also if the wires are reinforcing the closing situation the cable fixation element can be opened easily with two fingers due to the design of the hooks to be filled with more wires if necessary.

The open direction of the wires results in the fact that more wires can be placed into the cable fixation element.

A twist protection ensures the correct assembly.
The design of the fixing of the cable fixation element make it possible to fix the head profile for secondary equipment in one step.

### Numbering:

- 1: cable fixation element
- 2: c-shaped portions, complementary hooks
- 2': c-shaped portions, complementary hooks
- 3: fixing nose
- 4: double layerd structure
- 5: switchboard

## Claims

1. Cable fixation element in low voltage compartments with an openable ring element, through which a number of cables can be aligned in parallel, wherein the cable fixation element has means, by which the cable fixation element can be fixed on a cable mounting board,
**characterized in,**
**that** the ring is openable in that way, that the physical opening direction is perpendicular to the long axis of the cables, which have to be placed in the cable fixation element (1).

2. Cable fixation element according to claim 1,
**characterized in,**
**that** the ends of the openable ring are provided with complementarily formed C-structured portions (2, 2'), which interlocks in the closed position of the cable fixation element (1), and can be opened by a sidewarded relative contrary side movement in a remove direction, and can be closed by a movement in succession to another.

3. Cable fixation element according to claim 1 or 2,
**characterized in,**
**that** the cable fixation element (1) has a fixing nose (3) for an intended twist protection, which ensures that the cable fixation element (1) can be assembled in one direction only, which ensures that the opening is on the right position for installation an maintenance.

4. Cable fixation element according to one of the aforesaid claims,
**characterized in,**
**that** the cable fixation element (1) has a further integrated fixing element, which is additionally applicable for fixing the head profile for low voltage-components too.

5. Cable fixation element according to one of the aforesaid claims,
**characterized in,**
**that** the cable fixation element (1) including all aforesaid portions, fixing element, fixing nose and c-structured portions are formed as a one-piece element, so that all aforesaid parts and portions are integrally formed at the cable fixation element.

6. Cable fixation element according to one of the aforesaid claims,
**characterized in,**
**that** the frame structure of the cable fixation element is provided at all sides of the frame in double layer (4), except of the top side, where the c-structued portions (2, 2') are implemented.

7. Cable fixation element according to claim 5 or 6,
**characterized in,**
**that** the cable fixation element (1) is embellished as injection or cast moulded element.
